# EUROPEAN PATENT APPLICATION

(11) **EP 4 648 556 A1**
(43) Date of publication of application: **12.11.2025**
(21) Application number: 24738720.2
(22) Date of filing: 04.01.2024
(51) Int. Cl.: H05K 3/32, H01R 13/15, H05K 1/14

(54) **ASSISTANT ELASTIC PART FOR SIGNAL CONNECTION AND SUBSTRATE ASSEMBLY INCLUDING SAME**

(30) Priority: 04.01.2023 KR 20230001345; 03.01.2024 KR 20240000682
(71) Applicant: KMW Inc., Hwaseong-si, Gyeonggi-do 18462 (KR)
(72) Inventor: JEONG, Bae Mook, Suwon-si Gyeonggi-do 16545 (KR); AHN, Seong Min, Namyangju-si Gyeonggi-do 12109 (KR)
(74) Representative: Impuls legal PartG mbB
(86) International application number: PCT/KR2024/000155
(87) International publication number: WO 2024/147650

(57) **Abstract**

Provided are an assistant elastic part for signal connection and a substrate assembly including the same. The assistant elastic part for signal connection includes an elastic pressing part that, of a substrate assembly including a first substrate member and a second substrate member that is stacked so that one surface thereof is in surface-contact with the first substrate member, applies an elastic force to the second substrate member and maintains electrical signal connection between mutually facing surfaces of the first substrate member and the second substrate member, and the elastic pressing part includes an elastic rib that is provided to press the second substrate member by an elastic force of a material of the elastic rib, thereby reducing the product manufacturing cost and providing the advantage of maintaining RF characteristics with only low-cost components.

## Description

### [Technical Field]

The present disclosure relates to an assistant elastic part for signal connection and a substrate assembly including the same, and more specifically, to an assistant elastic part for signal connection that can maintain stable signal connection and linkage between at least two surface-contact members (including substrates) even without a separate soldering process and a substrate assembly including the same.

### [Background Art]

Generally, a printed circuit board (PCB, plastic circuit board) is a plate-shaped board made of a dielectric material having a predetermined dielectric constant, and is one of signal transmission components in which a predetermined signal line is pattern-printed with a conductive material on both surfaces or at least one surface thereof to serve to provide a transmission path that branches or integrates signals.

Recently, the most commonly applied material for the printed circuit board is a glass-fiber epoxy (FR-4) material or a Teflon material. Since it is easy to process through holes in the FR-4 material, the FR-4 material is generally used as a main board form of a product with a multilayer that can provide various transmission paths. Since the Teflon material is a high-strength material with low dielectric constant and excellent high-frequency characteristics, it is used in RF (high frequency, UHF, SHF, EHF) circuits, but it is not easily processed due to its high strength and thus can be produced only for some PCBs. In addition, since the Teflon material has the disadvantage of being expensive, it is used as a sub-board form to replace a part of a main board or to exhibit desired circuit performance (RF characteristics) by being stacked on the main board.

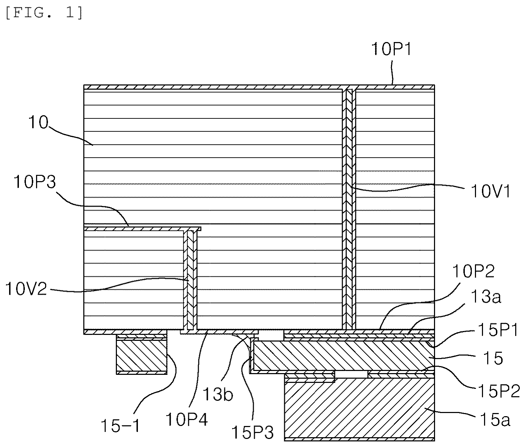

FIG. 1 is a part of a cross-sectional view for explaining the signal connection structure of two general members (including substrates).

As illustrated in FIG. 1, an electrical element (not illustrated) can be mounted on one surface of a main board 10 provided as a multilayer made of a FR-4 material, and a sub-board 15 provided as a double-sided PCB made of a Teflon material can be stacked on the other surface of the main board 10 to have a predetermined joint surface that is mutually joined.

As illustrated in FIG. 1, an analog RF-related component 15a (for example, a PA element or the like among components of an antenna device) can be mounted on the sub-board 15, and can be adopted as a heat generation electrical element that generates heat while operating by receiving a power supply signal.

The main board 10 and the sub-board 15 are two members that are in surface-contact with each other, and can be electrically signal-connected through mutually stacked surface-contact.

To this end, as illustrated in FIG. 1, a first main conductive pattern 10P1 may be pre-printed on a surface (hereinafter, referred to as an 'upper surface') opposite to a surface (hereinafter, referred to as a 'lower surface') of the main board 10 that faces the sub-board 15, and a second main conductive pattern 10P2 may be pre-printed on the lower surface of the main board 10.

In addition, a first sub-conductive pattern 15P1 may be pre-printed on a surface (hereinafter, referred to as an 'upper surface') of the sub-board 15 that faces the lower surface of the main board 10, and when stacked and bonded, signal connection points (not illustrated) of the second main conductive pattern 10P2 and the first sub-conductive pattern 15P1 are linked and electrically connected via a flat soldering material (see reference numeral '13a' of FIG. 1) such as solder paste.

The first main conductive pattern 10P1 and the second main conductive pattern 10P2 of the main board 10 can be electrically connected to each other via a first via hole 10V1 extended through the upper surface to the lower surface of the main board 10.

The main board 10 provided as a multilayer does not necessarily need to have the first main conductive pattern 10P1 and the second main conductive pattern 10P2 only on the upper surface and the lower surface thereof, and as illustrated in FIG. 1, a fourth main conductive pattern 10P4 can also be pre-printed on a different portion of the second main conductive pattern 10P2 of the lower surface of the main board 10 in order to receive signals via a third main conductive pattern 10P3 pre-printed in the multilayer and a second via hole 10V2 formed through for interlayer electrical connection.

In particular, when an electrical element is mounted on the lower surface of the sub-board 15 as the RF-related component 15a, as illustrated in FIG. 1, a signal transmitted from the third main conductive pattern 10P3 of the main board 10 can be transmitted to the fourth main conductive pattern 10P4 of the lower surface via the second via hole 10V2, transmitted to the second sub-conductive pattern 15P2 pre-printed on the lower surface of the sub-board 15 via a through-pattern portion 15P3 of the sub-board 15 provided as the double-sided PCB, and then supplied to the RF-related component 15a.

However, in the electrical signal connection structure in which two members (substrate members) are directly joined without a separation distance, a soldering process using a separate soldering material such as solder paste is essential to ensure the reliability of the connection of the mutual signal connection points, leading to problems such as excessive assembly time and labor investment as well as increased product cost.

In addition, when the RF-related component 15a is mounted on the lower surface of the sub-board 15, there is a problem in that the fourth main conductive pattern 10P4 at a portion joined to the main board 10 is inevitably exposed to the outside and at the same time, a connection hole processing process of processing a signal connection hole 15-1 that penetrates a part of the sub-board 15 in order to form the through-pattern portion 15P3 needs be inevitably performed. In such a case, an additional soldering process is required to connect the fourth main conductive pattern 10P4 and the through-pattern portion 15P3 by a soldering method using a soldering material (see reference numeral '13b' of FIG. 1).

In particular, for the signal connection of two members (substrates) where RF characteristics need be prioritized, as disclosed in Korean Patent No. 10-1301772 (currently expired) being the related art, using a type of RF connector is most preferable regardless of whether the mutually facing surfaces are separated by a predetermined distance, but the RF connector has the problem of increasing the overall product manufacturing cost and increasing the burden on consumers because it is very expensive.

Therefore, research is being actively conducted to develop a new connection structure of minimizing an increase in cost when connecting signals between two members, and in such a case, in the signal connection structure of the two members where maintenance of RF characteristics is important, impedance matching design for securing signal quality reliability from unreasonable installation environments such as external vibrations remains a very important challenge.

### [Disclosure]

### [Technical Problem]

The present disclosure is directed to providing an assistant elastic part for signal connection that can reduce the product manufacturing cost by eliminating a soldering process that is necessarily performed for signal connection between two substrate members in the related art, and a substrate assembly including the same.

In addition, the present disclosure is directed to providing an assistant elastic part for signal connection that is advantageous in maintaining RF characteristics and prevents signal quality degradation by securing a good return loss value and isolation value, while enabling application of an automated assembly process, and a substrate assembly including the same.

Technical problems of the present disclosure are not limited to the above-described problems, and other problems that are not mentioned will be able to be clearly understood by those skilled in the art from the following description.

### [Technical Solution]

In order to achieve the objects, an assistant elastic part for signal connection according to an embodiment of the present disclosure includes an elastic pressing part that, of a substrate assembly including a first substrate member and a second substrate member that is stacked so that one surface thereof is in surface-contact with the first substrate member, applies an elastic force to the second substrate member and maintains electrical signal connection between mutually facing surfaces of the first substrate member and the second substrate member, and the elastic pressing part includes an elastic rib that is provided to press the second substrate member by an elastic force of a material of the elastic rib.

The first substrate member may be a main board printed with at least one main conductive pattern on a surface facing the second substrate member, the second substrate member may be a sub-board printed with at least one sub-conductive pattern on a surface facing the first substrate member, the sub-conductive pattern being electrically connected to the main conductive pattern, and signal disconnection between the main conductive pattern and the sub-conductive pattern may be prevented by the elastic pressing part.

In addition, the elastic pressing part may further include a support pad that supports the elastic rib to one surface of the support pad with the first substrate member in between, and an elastic means provided on the other surface of the support pad to apply an elastic force to the support pad.

In addition, the elastic rib may be made of a non-conductive material, and be made of a dielectric material having a dielectric constant of 2.7 to 3.5.

In addition, the elastic rib may be formed to have a hardness of 60 HV to 75 HV.

In addition, when the first substrate member and the second substrate member are arranged in a stacked manner on a front inner surface of the heat dissipation housing so that the first substrate member is arranged relatively forward and a clamshell cover is arranged in front of the first substrate member to cover the at least one main conductive pattern, the elastic pressing part may have a size such that at least a part of the elastic pressing part is exposed further forward than a rib installation groove formed on the front inner surface of the heat dissipation housing.

In addition, one elastic rib may be inserted into the rib installation groove having a rectangular vertical cross-section and provided to be long in a longitudinal direction, or a plurality of elastic ribs may be inserted into a plurality of rib installation grooves each having a circular vertical cross-section and spaced apart from each other.

In addition, when the elastic rib is provided to have a circular horizontal cross-section with a predetermined diameter, the rib installation groove may be formed to include a rectangular groove having a rectangular vertical cross-section with a width smaller than a diameter of the elastic rib and provided to be long in a longitudinal direction, and a plurality of circular grooves spaced apart from each other within the rectangular groove and provided to accommodate an outer peripheral surface of the elastic rib, and a plurality of elastic ribs may be provided to be inserted into the circular grooves of the rib installation groove, respectively.

In addition, the elastic rib may be elastically deformed when the first substrate member or the clamshell cover is fixed to the heat dissipation housing with a predetermined assembly force, thereby elastically supporting the second substrate member toward the first substrate member.

In addition, a plurality of main conductive patterns may be provided on the first substrate member so that main signal connection points, which are connection points with a sub-conductive pattern, are spaced apart from each other by a predetermined distance, a plurality of sub-conductive patterns may be provided on the second substrate member so that sub-signal connection points, which are connection points with the main conductive patterns, are arranged at positions corresponding to the main signal connection points, respectively, and the elastic rib may be provided in a number corresponding to the numbers of main signal connection points and sub-signal connection points in order to secure an optimal isolation value within a signal channel provided through each of the main signal connection point and the sub-signal connection point.

In addition, the elastic rib may be arranged to support the second substrate member according to the optimal isolation value in a direction in which at least one elastic rib is in close contact with at least two of the main signal connection points and the sub-signal connection points.

In addition, the first substrate member may be provided with a first main board and a second main board that are separated and arranged to have back surfaces that are mutually matched with the heat dissipation housing, the second substrate member may be provided as a signal connection PCB that electrically connects the first main board and the second main board, and the elastic rib may be provided to elastically support the second substrate member provided with at least one or more signal connection PCBs at the same time toward a back surface including a dividing boundary line that divides the first main board and the second main board.

In addition, the first main board may be an RF transceiver PCB, the second main board may be a digital board PCB, and the elastic rib may be provided in a number corresponding to the number of signal connection points of main conductive patterns formed on a back surface of each of the first main board and the second main board and sub-conductive patterns formed on the second substrate member.

A substrate assembly according to an embodiment of the present disclosure may include the assistant elastic part for signal connection.

### [Advantageous Effects]

An assistant elastic part for signal connection and a substrate assembly including the same according to an embodiment of the present disclosure can achieve the following various effects.

First, it has the effect of reducing the overall product manufacturing cost by completely eliminating a soldering process for signal connection between two substrate members arranged to be in surface-contact with each other.

Second, it has the effect of making it easy to design impedance matching between signal channels in order to maintain RF characteristics, and improving the signal quality of antenna devices adopting the frequency system of a FDD method as well as a TDD method.

### [Description of Drawings]

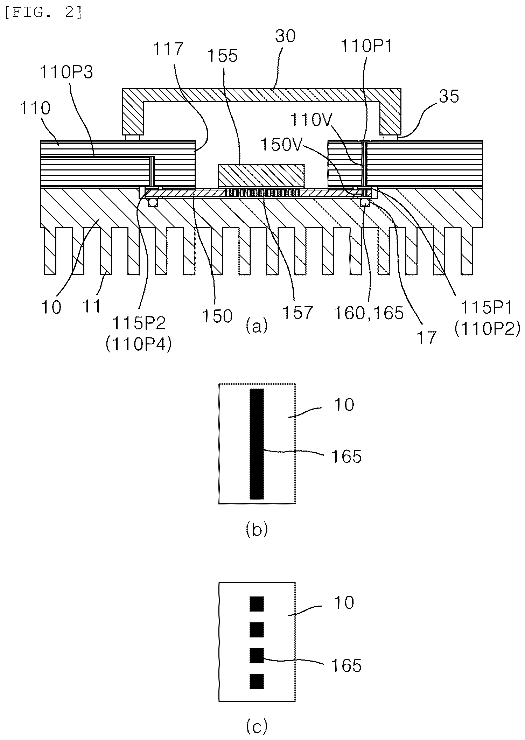

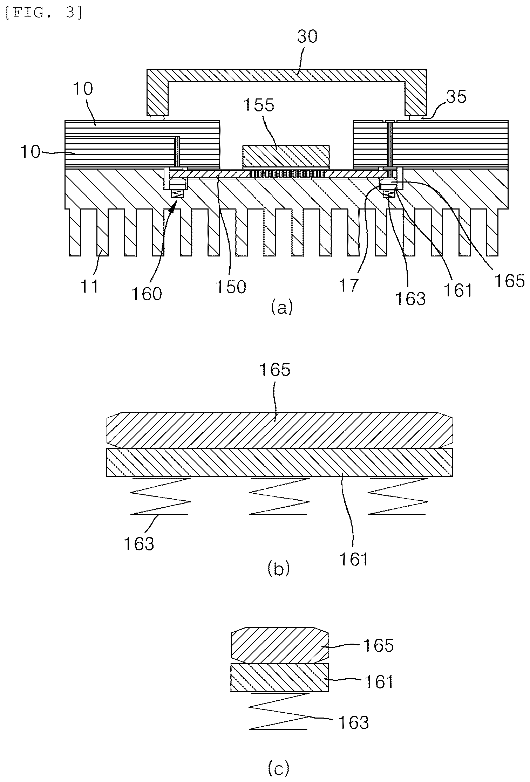

FIG. 1 is a part of a cross-sectional view for explaining the signal connection structure of two general members (including substrates).
(a) of FIG. 2 is a cross-sectional view illustrating a substrate assembly including an assistant elastic part for signal connection according to a first embodiment of the present disclosure, and (b) and (c) of FIG. 2 are plan views of a part of the substrate assembly.
(a) of FIG. 3 is a cross-sectional view illustrating a substrate assembly including an assistant elastic part for signal connection according to a second embodiment of the present disclosure, and (b) and (c) of FIG. 3 are plan views of a part of the substrate assembly.
FIGS. 4a and 4b are cross-sectional views illustrating implementation examples of various substrate assemblies adopting the assistant elastic parts for signal connection according to the first embodiment and the second embodiment of the present disclosure applied to FIGS. 2 and 3.
FIG. 5 is a perspective view of some simulation design drawings of a substrate assembly designed to confirm the effect of an assistant elastic part for signal connection according to a third embodiment of the present disclosure through a simulation.
FIGS. 6a and 6b are a downward exploded perspective view and an upward exploded perspective view of FIG. 5.
FIG. 7 is a cutaway perspective view taken along line A-A in FIG. 5.
FIG. 8 is a perspective view and plan views illustrating signal connection patterns of a first substrate member and a second substrate member among components in FIG. 5.
(a) and (b) of FIG. 9 are plan views of components illustrating the substrate assembly including the assistant elastic part for signal connection according to the third embodiment of the present disclosure, and (c) of FIG. 9 is a side view thereof.
FIG. 10 is a cross-sectional view and a partially enlarged view thereof illustrating a stack installation appearance for a heat dissipation housing in FIG. 9.
FIG. 11 is a plan view, a front view, a side view, and a bottom view illustrating signal connection pattern types of a first substrate member and a second substrate member among the components in FIG. 9 and various types of the assistant elastic part for signal connection supported thereon.
FIGS. 12a and 12b are a plan view, a front view, a side view, and a bottom view illustrating different design appearances according to a required isolation value between ports according to the signal connection pattern among components of FIG. 11.
FIG. 13 is a graph showing frequency characteristic values using the simulation design diagram of FIG. 9.

### <Description of reference numerals>

10: Heat dissipation housing 11: Heat transfer fin
30: Clamshell cover 35: EMI shield rib
110: First substrate member (main board) 110P: Main conductive pattern
110P-1,110P-2: Signal connection point 150: Second substrate member (sub-board)
150P: Sub-conductive pattern 160: Elastic pressing part
161: Support pad 163: Elastic means
165: Elastic rib

### [Mode for Invention]

Hereinafter, an assistant elastic part for signal connection and a substrate assembly including the same according to an embodiment of the present disclosure are described in detail with reference to the accompanying drawings.

It is to be noted that in assigning reference numerals to elements in the drawings, the same reference numerals denote the same elements throughout the drawings even in cases where the elements are shown in different drawings. Furthermore, in describing the embodiments of the present disclosure, a detailed description of the known configurations or functions will be omitted when it is deemed to obscure the understanding for the embodiments of the present disclosure.

In describing the elements of the embodiments of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as the terms generally understood by those skilled in the art to which the present disclosure pertains. The terms, such as terms defined in dictionaries, which are generally used, should be interpreted as having meanings identical to contextual meanings of the related art, and are not interpreted as having ideal or excessively formal meanings unless they are definitely defined in the present disclosure.

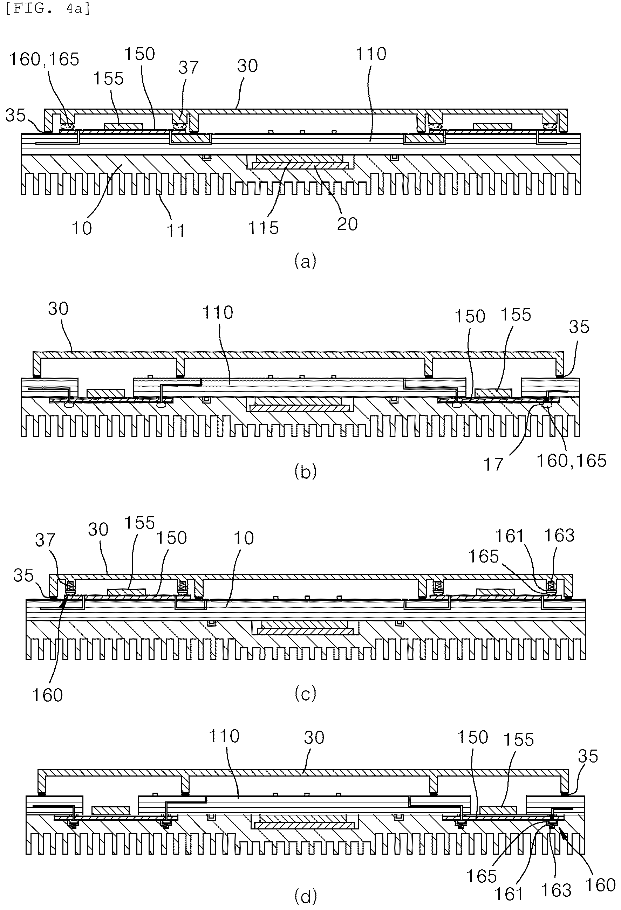

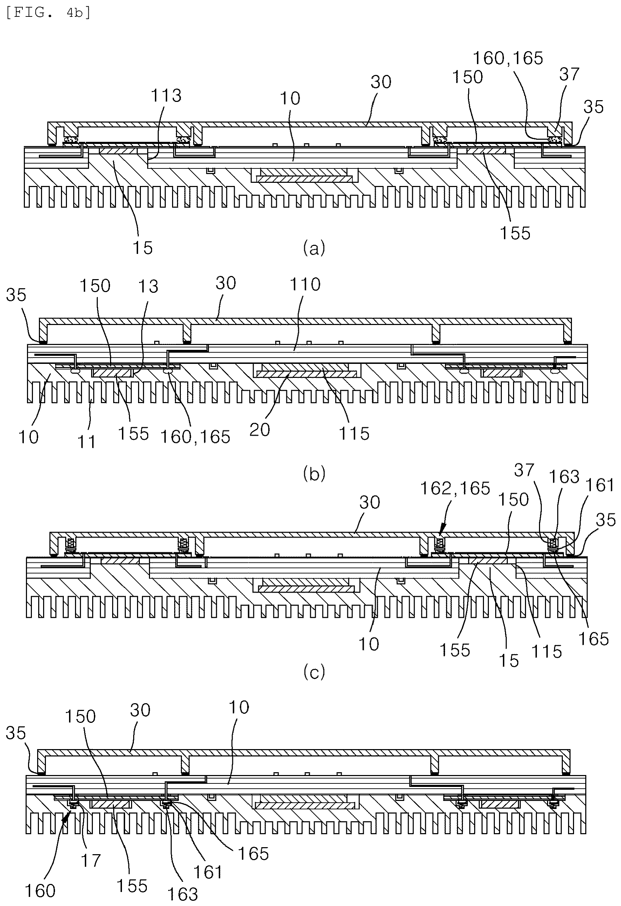

(a) of FIG. 2 is a cross-sectional view illustrating a substrate assembly including an assistant elastic part for signal connection according to a first embodiment of the present disclosure, and (b) and (c) of FIG. 2 are plan views of a part of the substrate assembly, (a) of FIG. 3 is a cross-sectional view illustrating a substrate assembly including an assistant elastic part for signal connection according to a second embodiment of the present disclosure, and (b) and (c) of FIG. 3 are plan views of a part of the substrate assembly, and FIGS. 4a and 4b are cross-sectional views illustrating implementation examples of various substrate assemblies adopting the assistant elastic parts for signal connection according to the first embodiment and the second embodiment of the present disclosure applied to FIGS. 2 and 3.

The assistant elastic part for signal connection according to the present disclosure includes an elastic pressing part 160 that, in the substrate assembly including a first substrate member 110 (hereinafter, referred to as a 'main board') on which at least one main conductive pattern is printed and a second substrate member 150 (hereinafter, referred to as a 'sub-board') that is stacked so that one surface thereof is in surface-contact with the main board 110 and is printed with a sub-conductive pattern to be electrically connected to the main conductive pattern formed on the main board 110, applies an elastic force to the sub-board 150 and prevents signal disconnection between the main conductive pattern and the sub-conductive pattern.

In accordance with the first embodiment of the assistant elastic part for signal connection according to the present disclosure, the elastic pressing part 160 can be defined as including an elastic rib 165 provided to press the sub-board 150 by an elastic force of its own material, as illustrated in FIG. 2.

More specifically, as illustrated in FIG. 2, the substrate assembly adopting the assistant elastic part for signal connection of the first embodiment is configured to elastically support the sub-board 150 toward the main board 110 by the elastic pressing part 160 provided with the elastic rib 165 having an elastic force due to its own material.

On both surfaces of the main board 110, as the above-described main conductive pattern, a first main conductive pattern 110P1 and a second main conductive pattern 110P2 can be pattern-printed, and a third main conductive pattern 110P3 and a fourth main conductive pattern 110P4 can be pattern-printed on an interlayer portion of the main board 110 provided as a multilayer and a back surface of the main board 110 corresponding thereto. The main board 110 can be formed with a first via hole 110V1 for electrically conducting electricity between the first main conductive pattern 110P1 and the second main conductive pattern 110P2 and a second via hole 110V2 for electrically conducting electricity between the third main conductive pattern 110P3 and the fourth main conductive pattern 110P4.

However, for the convenience of explanation, in an embodiment of the present disclosure, it is assumed that the second main conductive pattern 110P2 and the fourth main conductive pattern 110P4 are provided respectively; however, the second main conductive pattern 110P2 and the fourth main conductive pattern 110P4 may be omitted or deleted as long as ends of the first via hole 110V1 and the second via hole 110V2 are directly joined to a first sub-conductive pattern 150P1 and a second sub-conductive pattern 150P2 of the sub-board 150 to be described below.

In addition, the front surface of the sub-board 150 may include the first sub-conductive pattern 150P1 and the second sub-conductive pattern 150P2 pattern-printed at positions corresponding to rear ends of the second main conductive pattern 110P2 and the fourth main conductive pattern 110P4 or the first via hole 110V1 and the second via hole 110V2, respectively.

In FIG. 2, the same indication line is used because it is difficult to distinguish between the second main conductive pattern 110P2 and the first sub-conductive pattern 150P1 and between the fourth main conductive pattern 110P4 and the second sub-conductive pattern 150P2, but it can be understood that the patterns are formed to be physically distinguished from each other.

The assistant elastic part for signal connection of the present disclosure implemented as the first embodiment includes the elastic rib 165 that is inserted into a rib installation groove 17 formed in advance on an inner surface of a heat dissipation housing 10 provided so that the main board 110 and the sub-board 150 are stacked, as illustrated in FIG. 2.

A plurality of digital semiconductor components (see reference numeral '115' in FIGS. 4a and 4b) (for example, FPGA components) and analog RF-related components 155 (for example, PA components or the like among components of an antenna device) can be mounted on the main board 110 and the sub-board 150 stacked on the inner surface of the heat dissipation housing 10, and in particular, the RF-related component 155 can be adopted as a heat generation electrical element that generates heat while operating by receiving a power supply signal.

When the RF-related component 155 is mounted on the front surface of the sub-board 150 stacked on the back surface of the main board 110, as illustrated in (a) of FIG. 2, the front surface of the sub-board 150 can be exposed to the outside through an exposed portion 117 formed by cutting the main board 110 in the frontward and rearward direction and the RF-related component 155 can be mounted.

In addition, on the front surface of the main board 110 on which the above-described exposed portion 117 is processed so that the RF-related component 115 is mounted, a clamshell cover 30 can be arranged to shield interference between a signal channel formed by the RF-related component 155 and an external signal.

An EMI shield rib 35 can be provided at a distal end of the clamshell cover 30 that comes into contact with the front surface of the main board 110, can be applied to the main board 110 in advance through an EMI dispensing method, and can be fixed when the clamshell cover 30 is assembled.

However, when the sub-board 150 is stacked on the front surface of the main board 110, it is obvious that the EMI shield rib 35 provided at the distal end of the clamshell cover 30 can be applied to the sub-board 150 in advance and fixed.

Heat generated from the RF-related component 155 mounted on the front surface of the sub-board 150 can be transferred to the inner surface of the heat dissipation housing 10 through a plurality of heat transfer holes 157 formed through the back surface of the sub-board 150 and filled with a heat transfer material having a predetermined thermal conductivity, and can be dissipated to the outside through a plurality of heat transfer fins 11 integrally formed on the back surface of the heat dissipation housing 10.

As illustrated in (a) of FIG. 2, the elastic rib 165 may have a size such that at least a part thereof is exposed to the outside from the distal end of the clamshell cover 30 or the rib installation groove 17 formed on the heat dissipation housing 10. However, as illustrated in (c) of FIG. 4a and (c) of FIG. 4b, the rib installation groove 37 can be formed at the distal end (or partition rib) of the clamshell cover 30 and the same is applied in this case.

The clamshell cover 30 can be assembled by fastening a number of assembly screws (not illustrated) to the heat dissipation housing 10, and can be fixed to the heat dissipation housing 10 while providing an assembly force for pressing at least one of the main board 110 and the sub-board 150 toward the inner surface of the heat dissipation housing 10.

However, the assembly force transmitted to the sub-board 150 is not limited to an assembly force provided when the clamshell cover 30 is assembled, and since the main board 110 can also be fixed to the inner surface of the heat dissipation housing 10 by an assembly screw (not illustrated), it is obvious that in this case, the assembly force of the clamshell cover 30 can be additionally transmitted in addition to the assembly force of the main board 110.

The assembly force of the clamshell cover 30 can act as an external force that elastically deforms a portion exposed to the outside of the elastic rib 165 inserted into the rib installation groove 17 to be described below.

On the other hand, one elastic rib 165 may be inserted in a linear shape into the rib installation groove 17 provided to be linearly (for example, in a straight line shape) continuous as illustrated in (b) of FIG. 2, or a plurality of elastic ribs 165 may be inserted in a dot shape into the rib installation groove 17 provided to be spaced apart from one another in a dot shape as illustrated in (c) of FIG. 2.

More specifically, as illustrated in (b) of FIG. 2, the rib installation groove 17 formed on the inner surface of the heat dissipation housing 10 may be provided to have a rectangular vertical cross-section and to be long in a longitudinal direction, and one elastic rib 165 may be arranged in such a rib installation groove 17.

In addition, as illustrated in (c) of FIG. 2, the rib installation groove 17 formed on the inner surface of the heat dissipation housing 10 may be provided in a plural number each having a circular vertical cross-section and spaced apart from one another, and a plurality of elastic ribs 165 each having a circular vertical cross-section may be arranged in the rib installation grooves 17, respectively.

An assistant elastic part for signal connection according to a second embodiment of the present disclosure may include an elastic pressing part 160 provided in the form of an assembly as illustrated in FIG. 3.

As illustrated in FIG. 3, the elastic pressing part 160 may further include a support pad 161 that supports the elastic rib 165 to one surface with the sub-board 150 in between, and an elastic means 163 provided on the other surface of the support pad 161 to apply an elastic force to the support pad 161.

As illustrated in (b) and (c) of FIG. 3, at least two elastic means 163 can be provided in the form of a coil spring (or a spring spring) to elastically support one support pad 161 in a balanced manner.

As in the first embodiment, in the assistant elastic part for signal connection having such a configuration according to the second embodiment of the present disclosure, when the sub-board 150 is in completely close contact with the inner surface of the heat dissipation housing 10 together with the main board 110 by an assembly force provided when the clamshell cover 30 is assembled to the heat dissipation housing 10 by using an assembly screw, the elastic rib 165 is elastically deformed to elastically press the sub-board 150 toward the main board 110.

In such a case, it is necessary to secure an optimal return loss value for each signal channel formed by the main board 110 or the sub-board 150 and the clamshell cover 30 as the portion where the RF-related component 155 is mounted.

To this end, the elastic rib 165 provided in the elastic pressing part 160 may be made of a non-conductive material, and may be made of a dielectric material having a dielectric constant of 2.7 to 3.5.

In addition, the elastic rib 165 may be formed to have a hardness of 60 HV to 75 HV in that the sub-board 150 needs be elastically supported by an assembly force transmitted when the above-described clamshell cover 30 is assembled.

On the other hand, in the assistant elastic part for signal connection according to the first embodiment and the second embodiment of the present disclosure, when the sub-board 150 is stacked on the front surface of the main board 110 as illustrated in FIGS. 4a and 4b (see (a) and (c) of FIG. 4a and (a) and (c) of FIG. 4b), the elastic rib 165 can also be provided to press the distal end of the clamshell cover 30 or the distal end of a partition rib (not illustrated) that partitions each signal channel. In this case, it is obvious that the rib installation groove 37 into which the elastic rib 165 of the first embodiment or the elastic pressing part 160 of the second embodiment is inserted can be formed at the distal end of the clamshell cover 30 or the partition rib.

In addition, it is obvious that the assistant elastic part for signal connection according to the first and second embodiments of the present disclosure can be applied equally not only when the RF-related component 155 is mounted on the front surface of the sub-board 150 as illustrated in FIG. 4a, but also when the RF-related component 155 is mounted on the back surface of the sub-board 150 (that is, the inner surface side of the heat dissipation housing 10) as illustrated in FIG. 4b.

In the related art, a signal connection point (not illustrated) and a heat generating surface (not illustrated) of the RF-related component 155 mounted on the sub-board 150 are formed only on the same surface, so that the RF-related component 155 can be mounted only on the front surface of the sub-board 150 for heat dissipation and electrical signal connection as illustrated in FIG. 4a. However, recently, the signal connection point and the heat generating surface of the RF-related component 155 can be formed on different surfaces, so that the RF-related component 155 can also be mounted on the back surface of the sub-board 150 as illustrated in FIG. 4b. This can be seen as a difference from the related art.

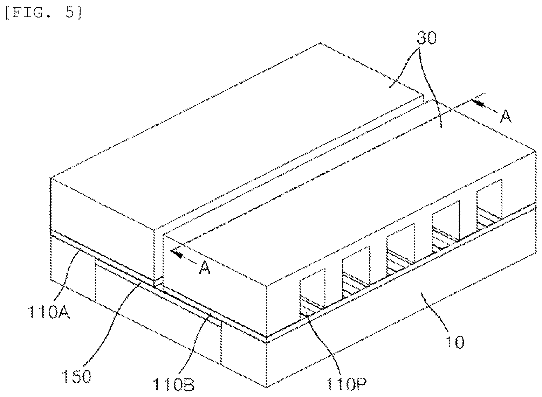

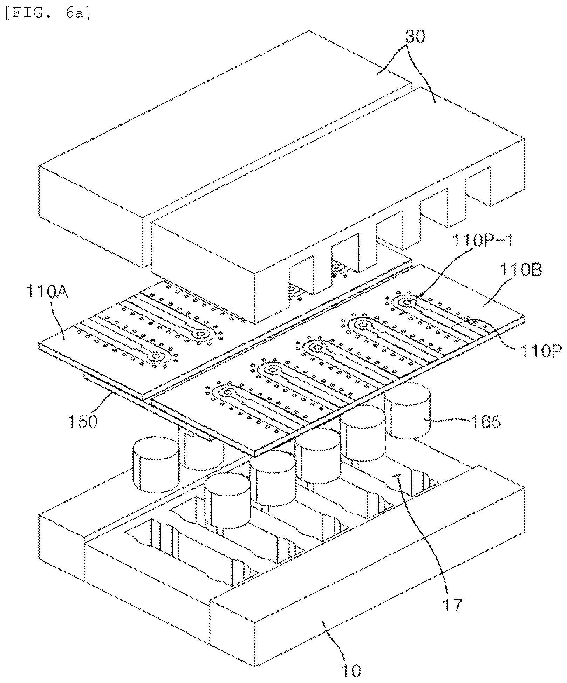

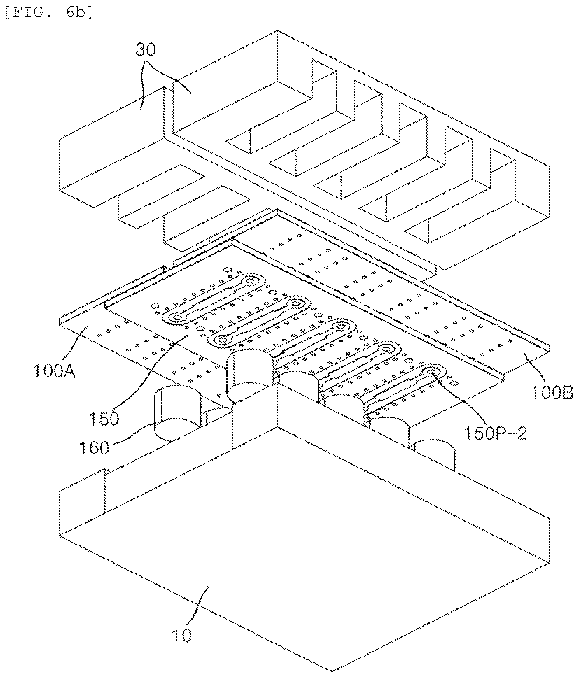

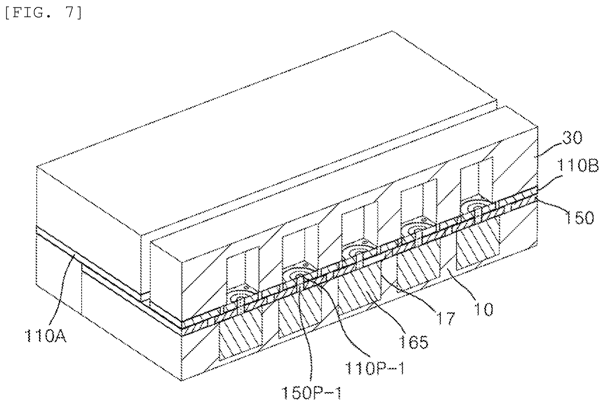

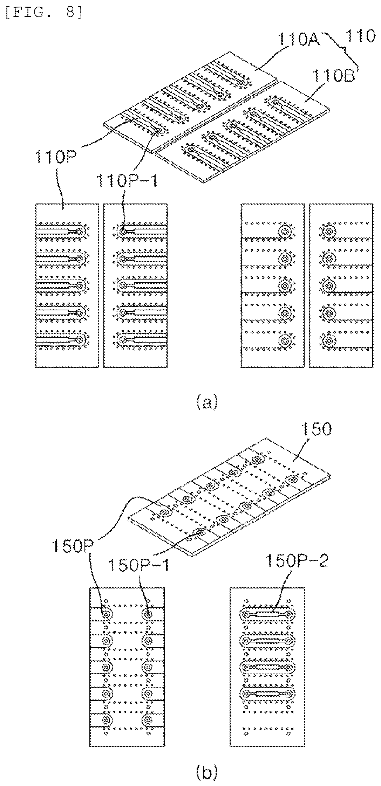

FIG. 5 is a perspective view of some simulation design drawings of a substrate assembly designed to confirm the effect of an assistant elastic part for signal connection according to a third embodiment of the present disclosure through a simulation, FIGS. 6a and 6b are a downward exploded perspective view and an upward exploded perspective view of FIG. 5, FIG. 7 is a cutaway perspective view taken along line A-A in FIG. 5, and FIG. 8 is a perspective view and a plan view illustrating signal connection patterns of a first substrate member and a second substrate member among the components in FIG. 5.

The assistant elastic part for signal connection according to the third embodiment of the present disclosure can be arranged to secure an optimal isolation value between signal channels as illustrated in FIGS. 5 to 8.

More specifically, as illustrated in FIGS. 5 to 8, a plurality of main conductive patterns 110P can be provided on the front surface of the main board 110 so that main signal connection points 110P-1, which are connection points with a plurality of sub-conductive patterns 150P formed on the front surface of the sub-board 150 to be described below are spaced apart from each other by a predetermined distance, and the plurality of sub-conductive patterns 150P can be provided on the front surface of the sub-board 110 so that sub-signal connection points 150P-1, which are connection points with the main conductive patterns 110P, are arranged at positions corresponding to the main signal connection points 110P-1, respectively.

As illustrated in FIG. 8, the main board 110 can be provided with a first main board 110A and a second main board 110B that are separated into two and arranged to have back surfaces that are mutually matched with the heat dissipation housing 10, and the sub-board 150 can be provided as a signal connection PCB that electrically connects the first main board 110A and the second main board 110B.

The elastic rib 165 can be provided to elastically support the sub-board 150 provided with at least one or more signal connection PCBs at the same time toward the back surface including a dividing boundary line 110T that divides the first main board 110A and the second main board 110B.

As illustrated in FIG. 6a, a plurality of elastic ribs 165 can be provided to be inserted into the rib installation grooves 17 provided on the inner surface of the heat dissipation housing 110 for installation.

More specifically, when the elastic rib 165 is provided to have a circular horizontal cross-section with a predetermined diameter, the rib installation groove 17 may be formed to include, as illustrated in FIG. 6a, a rectangular groove 17a having a rectangular vertical cross-section with a width smaller than the diameter of the elastic rib 165 and provided to be long in the longitudinal direction, and a plurality of circular grooves 17b spaced apart from each other within the rectangular groove 17a and provided to accommodate the outer peripheral surface of the elastic rib 165. In such a case, a plurality of elastic ribs 165 may be provided to be inserted into the respective circular grooves 17b.

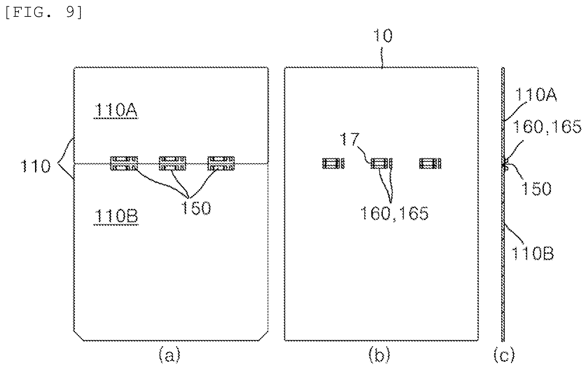

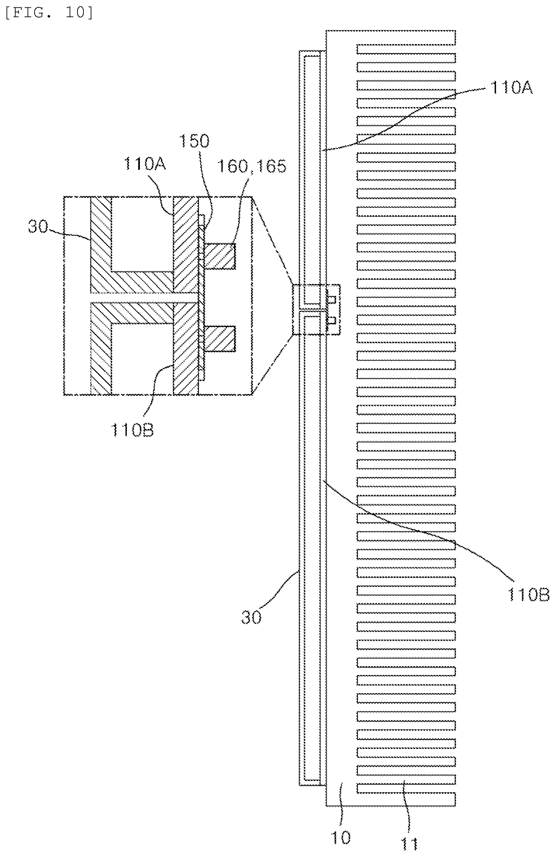

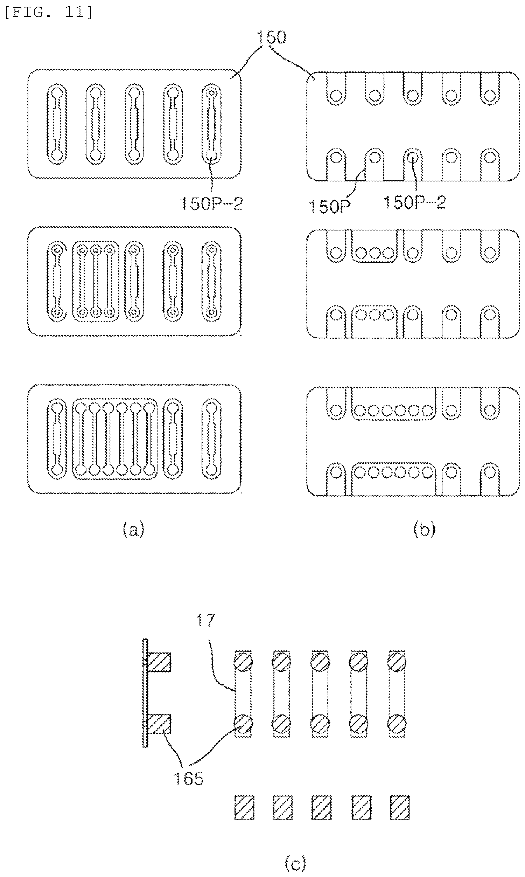

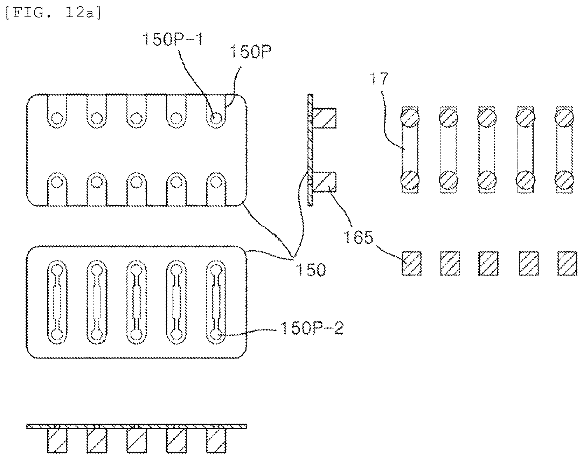

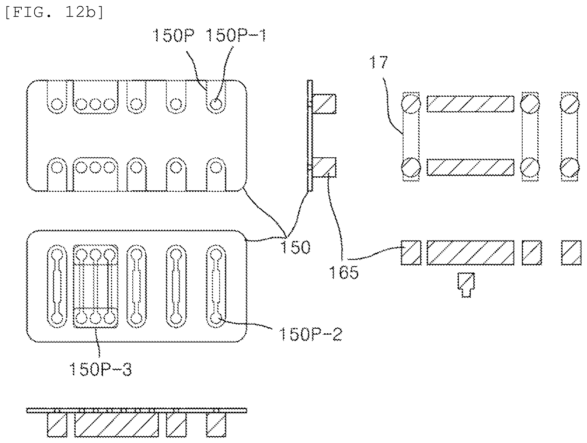

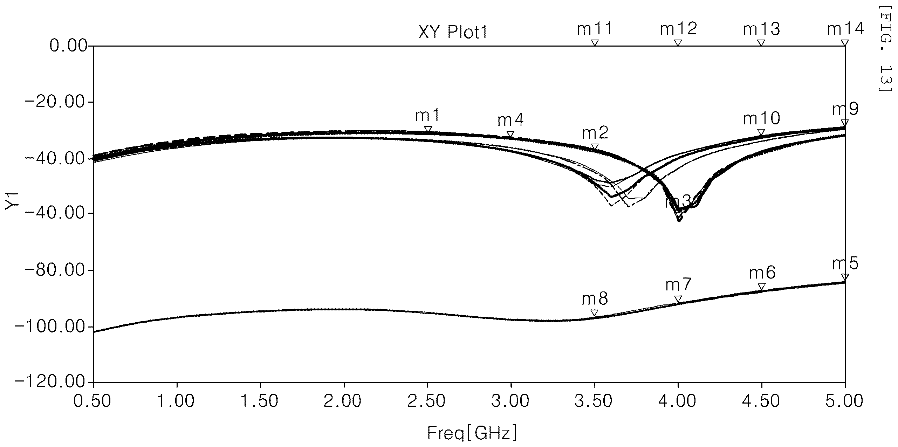

(a) and (b) of FIG. 9 are plan views of components illustrating the substrate assembly including the assistant elastic part for signal connection according to the third embodiment of the present disclosure, and (c) of FIG. 9 is a side view thereof, FIG. 10 is a cross-sectional view and a partially enlarged view thereof illustrating a stack installation appearance for a heat dissipation housing in FIG. 9, FIG. 11 is a plan view, a front view, a side view, and a bottom view illustrating signal connection pattern types of a first substrate member and a second substrate member among the components in FIG. 9 and various types of the assistant elastic part for signal connection supported thereon, FIGS. 12a and 12b are a plan view, a front view, a side view, and a bottom view illustrating different design appearances according to a required isolation value between ports according to the signal connection pattern among components of FIG. 11, and FIG. 13 is a graph showing frequency characteristic values using the simulation design diagram of FIG. 9.

As illustrated in FIG. 11 and FIGS. 12a and 12b, on the front surface of the sub-board 150 provided as a signal connection PCB, the sub-signal connection point 150P-1 that mutually contacts each main signal connection point 110P-1 of the plurality of main conductive patterns 110P formed on the back surface of the first main board 110A and the second main board 110B can be pattern-printed (see (b) of FIG. 11), and an element connection point 150P-2 for connection with the RF-related component 155 can be provided in the form of a signal channel on the back surface of the sub-board 150 (see (a) of FIG. 11).

As illustrated in FIG. 12a, the elastic rib 165 can be provided in a number corresponding to the main signal connection point 110P-1 and the sub-signal connection point 150P-1 in order to secure an optimal isolation value within the signal channel provided through each of the main signal connection point 110P-1 and the sub-signal connection point 150P-1.

However, it is not necessary to provide the elastic ribs 165 in a number corresponding to the signal channel, and the elastic ribs 165 can be provided in a number arranged so that at least one elastic rib 165 simultaneously supports two or more main signal connection points 110P-1 and sub-signal connection points 150P-1 according to the optimal isolation value.

For example, as illustrated in FIG. 12a, since the first main board 110A and the second main board 110B can be pattern-printed with the main signal connection point 110P-1 and the sub-signal connection point 150P-1 assuming only mutual RF multi-path signal connection, the arrangement position and number of elastic ribs 165 are preferably designed to correspond to each RF multi-path (signal channel). However, as illustrated in FIG. 12b, when a connection pattern 150P-3 for power and control signals is provided regardless of the RF multi-path (signal channel) as well as the multi-path, the elastic ribs 165 can be arranged so that at least one simultaneously supports two or more main signal connection points 110P-1 and sub-signal connection points 150P-1 according to the optimal isolation value.

In this way, the assistant elastic part for signal connection according to embodiments of the present disclosure is provided as the elastic rib 165 or the elastic pressing part 160 in the form of an assembly including the elastic rib 165 and elastically supports the sub-board 150, so that the sub-conductive pattern 150P and the sub-signal connection point 150P-1 of the sub-board 150 can always maintain contact with the main conductive pattern 110P and the main signal connection point 110P-1 of the main board 110 and not only the isolation value of a signal channel formed between the RF-related components 155 but also a desired return loss value can be secured, thereby improving the signal quality. This was confirmed through the following simulation.

That is, as illustrated in FIGS. 5 to 8, the applicant of the present disclosure designed a maximum length in the longitudinal direction to be 14 mm, separated the first main board 110A from the second main board 110B, and performed a simulation of the return loss value and the isolation value in the signal channel space between the main conductive pattern 110P and the sub-conductive pattern 150P in a state in which the first main board 110A and the second main board 110B are signal-connected to each other by the sub-board 150 provided as a signal connection PCB.

As a result, as illustrated in FIG. 13, it was confirmed that a perfect matching value of 31 dB or less can be secured as the return loss value in a 4 GHz min frequency band and an optimal isolation value of each signal channel space can be secured as a 91 dB value in the 4 GHz min frequency band.

In particular, as a result of performing a simulation by adjusting the spacing between signal channels by 5 mm, it was confirmed that optimal isolation value and return loss value desired by a designer can be secured by adjusting the spacing of the elastic rib 165 or the elastic pressing part 160 that is a specific component of the assistant elastic part for signal connection according to the embodiments of the present disclosure.

Therefore, for electrical connection (or signal connection), it is not always necessary to prepare an expensive soldering process as in the first substrate member 110 and the second substrate member 150, and in particular, even in antenna devices including RF-related components where maintenance of RF characteristics is very important, the advantage of significantly reducing the product manufacturing cost can be achieved by replacing the soldering process with a low-cost elastic rib 165 or elastic pressing part 160.

Although the substrate assembly according to an embodiment of the present disclosure has not been described in detail, it is sufficient to understand it as a concept including the assistant elastic part for signal connection according to the above-described various embodiments.

In the above, an assistant elastic part for signal connection and a substrate assembly including the same according to embodiments of the present disclosure have been described in detail with reference to the attached drawings. However, the embodiments of the present disclosure are not necessarily limited to the above-described embodiment, and it is obvious that various modifications and implementations within an equivalent range are possible by those skilled in the art to which the present disclosure pertains. Therefore, the true scope of the present disclosure is determined by the accompanying claims.

### [Industrial Applicability]

The present disclosure provides an assistant elastic part for signal connection that can reduce the product manufacturing cost by eliminating a soldering process that is necessarily performed for signal connection between two substrate members in the related art, and is advantageous in maintaining RF characteristics and prevents signal quality degradation by securing a good return loss value and isolation value, while enabling application of an automated assembly process, and a substrate assembly including the same.

## Claims

1. An assistant elastic part for signal connection comprising:
an elastic pressing part that, of a substrate assembly including a first substrate member and a second substrate member that is stacked so that one surface thereof is in surface-contact with the first substrate member, applies an elastic force to the second substrate member and maintains electrical signal connection between mutually facing surfaces of the first substrate member and the second substrate member,
wherein the elastic pressing part comprises:
an elastic rib that is provided to press the second substrate member by an elastic force of a material of the elastic rib.

2. The assistant elastic part for signal connection of claim 1, wherein the first substrate member is a main board printed with at least one main conductive pattern on a surface facing the second substrate member,
the second substrate member is a sub-board printed with at least one sub-conductive pattern on a surface facing the first substrate member, the sub-conductive pattern being electrically connected to the main conductive pattern, and
signal disconnection between the main conductive pattern and the sub-conductive pattern is prevented by the elastic pressing part.

3. The assistant elastic part for signal connection of claim 1, wherein the elastic pressing part further comprises:
a support pad that supports the elastic rib to one surface of the support pad with the first substrate member in between; and
an elastic means provided on the other surface of the support pad to apply an elastic force to the support pad.

4. The assistant elastic part for signal connection of claim 1, wherein the elastic rib is made of a non-conductive material, and is made of a dielectric material having a dielectric constant of 2.7 to 3.5.

5. The assistant elastic part for signal connection of claim 1, wherein the elastic rib is formed to have a hardness of 60 HV to 75 HV.

6. The assistant elastic part for signal connection of claim 1, wherein when the first substrate member and the second substrate member are arranged in a stacked manner on a front inner surface of the heat dissipation housing so that the first substrate member is arranged relatively forward and a clamshell cover is arranged in front of the first substrate member to cover the at least one main conductive pattern, the elastic pressing part has a size such that at least a part of the elastic pressing part is exposed further forward than a rib installation groove formed on the front inner surface of the heat dissipation housing.

7. The assistant elastic part for signal connection of claim 6, wherein one elastic rib is inserted into the rib installation groove having a rectangular vertical cross-section and provided to be long in a longitudinal direction, or a plurality of elastic ribs are inserted into a plurality of rib installation grooves each having a circular vertical cross-section and spaced apart from each other.

8. The assistant elastic part for signal connection of claim 6, wherein when the elastic rib is provided to have a circular horizontal cross-section with a predetermined diameter, the rib installation groove is formed to include a rectangular groove having a rectangular vertical cross-section with a width smaller than a diameter of the elastic rib and provided to be long in a longitudinal direction, and a plurality of circular grooves spaced apart from each other within the rectangular groove and provided to accommodate an outer peripheral surface of the elastic rib, and
a plurality of elastic ribs are provided to be inserted into the circular grooves of the rib installation groove, respectively.

9. The assistant elastic part for signal connection of claim 6, wherein the elastic rib is elastically deformed when the first substrate member or the clamshell cover is fixed to the heat dissipation housing with a predetermined assembly force, thereby elastically supporting the second substrate member toward the first substrate member.

10. The assistant elastic part for signal connection of claim 6, wherein a plurality of main conductive patterns are provided on the first substrate member so that main signal connection points, which are connection points with a sub-conductive pattern, are spaced apart from each other by a predetermined distance,
a plurality of sub-conductive patterns are provided on the second substrate member so that sub-signal connection points, which are connection points with the main conductive patterns, are arranged at positions corresponding to the main signal connection points, respectively, and
the elastic rib is provided in a number corresponding to numbers of the main signal connection points and the sub-signal connection points in order to secure an optimal isolation value within a signal channel provided through each of the main signal connection point and the sub-signal connection point.

11. The assistant elastic part for signal connection of claim 10, wherein the elastic rib is arranged to support the second substrate member according to the optimal isolation value in a direction in which at least one elastic rib is in close contact with at least two of the main signal connection points and the sub-signal connection points.

12. The assistant elastic part for signal connection of claim 6, wherein the first substrate member is provided with a first main board and a second main board that are separated and arranged to have back surfaces that are mutually matched with the heat dissipation housing,
the second substrate member is provided as a signal connection PCB that electrically connects the first main board and the second main board, and
the elastic rib is provided to elastically support the second substrate member provided with at least one or more signal connection PCBs at the same time toward a back surface including a dividing boundary line that divides the first main board and the second main board.

13. The assistant elastic part for signal connection of claim 12, wherein the first main board is an RF transceiver PCB, the second main board is a digital board PCB, and
the elastic rib is provided in a number corresponding to the number of signal connection points of main conductive patterns formed on a back surface of each of the first main board and the second main board and sub-conductive patterns formed on the second substrate member.

14. A substrate assembly comprising the assistant elastic part for signal connection of any one of claims 1 to 13.
